Europäisches Patentamt

European Patent Office

Office européen des brevets

(19)

(11) Veröffentlichungsnummer : **0 104 425**
**B1**

(12)  **EUROPÄISCHE PATENTSCHRIFT**

(45) Veröffentlichungstag der Patentschrift :
03.12.86

(21) Anmeldenummer : 83108264.9

(22) Anmeldetag : 22.08.83

(51) Int. Cl.⁴ : **H 03 K 19/086**

(54) **Schaltungsanordnung in ECL-Schaltungstechnik.**

(30) Priorität : 30.08.82 DE 3232199

(43) Veröffentlichungstag der Anmeldung :
04.04.84 Patentblatt 84/14

(45) Bekanntmachung des Hinweises auf die Patenterteilung : 03.12.86 Patentblatt 86/49

(84) Benannte Vertragsstaaten :
AT DE FR GB IT NL

(56) Entgegenhaltungen :
FR-A- 2 409 640
US-A- 3 978 347

(73) Patentinhaber : Siemens Aktiengesellschaft Berlin
und München
Wittelsbacherplatz 2
D-8000 München 2 (DE)

(72) Erfinder : Barré, Claude, Dipl.-Ing.
Implerstrasse 23
D-8000 München 70 (DE)

Jouve, 18, rue St-Denis, 75001 Paris, France

## Beschreibung

Die Erfindung bezieht sich auf eine Schaltungsanordnung in ECL-Schaltungstechnik mit einem Eingangsemitterfolger, einem Differenzverstärker mit emittergekoppelten Transistoren und einem Ausgangsemitterfolger für das nichtinvertierte Ausgangssignal.

Schaltungsanordnungen der ECL-Schaltungstechnik sind in zwei grundsätzlichen Ausführungen bekannt. Bei der einen Ausführungsform sind einem unmittelbar vom Eingangssignal gesteuerten Differenzverstärker mit zwei emittergekoppelten Transistoren zwei Emitterfolger zur Ausgabe des nichtinvertierten und des invertierten Ausgangssignals nachgeschaltet (ECL). Eine derartige Ausführungsform ist zum Beispiel in DE-A-2 751 881 beschrieben. Bei der anderen Ausführungsform ist dem Differenzverstärker ein Emitterfolger vorgeschaltet (E²CL) Ausgangsemitterfolger fehlen gewöhnlich, doch ist es für manche Zwecke vorteilhaft, auch hier Ausgangsemitterfolger vorzusehen. Ein dementsprechender Anwendungsfall liegt beispielsweise beim Einsatz in programmierbaren Logikanordnungen, insbesondere bei einer Verwendung als Eingangsstufen vor.

Ein wichtiges Ziel bei der Entwicklung von integrierten Schaltungsanordnungen ist die Verkleinerung des Produkts aus Verlustleistung und Schaltzeit. Der Erfindung liegt die Aufgabe zugrunde, bei der eingangs genannten Schaltungsanordnung in ECL-Schaltungstechnik die Verlustleistung ohne Erhöhung der Schaltzeit zu verringern. Gemäß der Erfindung wird diese Aufgabe durch das kennzeichnende Merkmal des Patentanspruchs 1 gelöst.

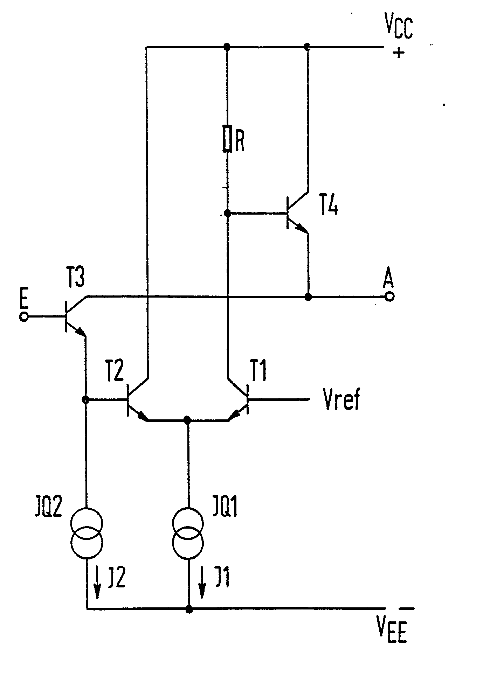

Im folgenden wird die Erfindung anhand eines in der Zeichnung dargestellten Ausführungsbeispiels näher beschrieben. Die Schaltungsanordnung enthält einen Differenzverstärker mit den emittergekoppelten Transistoren T1 und T2. Eine Stromquelle IQ1 liefert dem Differenzverstärker einen konstanten Strom I1. Die Basis des einen Transistors T1 liegt, wie gewöhnlich, an einem Referenzpotential $V_{ref}$. Die Basis des zweiten Transistors T2 ist mit dem Emitter eines als Emitterfolger betriebenen Transistors T3 verbunden, dessen Basis den Eingang E der Gesamtschaltung bildet. Einen mindestens annähernd konstanten Strom I2 zur Speisung des Eingangsemitterfolgers erzeugt eine gleichzeitig als Arbeitswiderstand dienende Stromquelle IQ2, die bekanntlich häufig durch einen Ohmschen Widerstand ersetzt wird.

Bei bekannten Schaltungsanordnungen der hier betrachteten Art besitzt der Ausgangsemitterfolger eine eigene Stromquelle. Das trifft auch auf Ausführungen mit einem offenen Emitter zu, da hierbei eine Stromquelle bzw. ein dazu äquivalenter, gegen das emitterseitige Versorgungspotential $V_{EE}$ geschalteter Widerstand nur räumlich, d. h. auf die Seite eines nachfolgenden Signalempfängers verlagert ist.

Gemäß der Erfindung ist dagegen der Emitter des Transistors T4 zur Bildung des Ausgangsemitterfolgers mit dem Ausgang A mit dem Kollektor des Transistors T2 des Eingangsemitterfolgers verbunden. Die Stromquelle IQ2 des Eingangsemitterfolgers bildet dann gleichzeitig auch die Stromquelle für den Ausgangsemitterfolger.

Die erfindungsgemäße Schaltungsmaßnahme ist nur für einen Ausgangsemitterfolger verwendbar, der entsprechend der Darstellung in der Zeichnung an den nichtinvertierenden Ausgang des Differenzverstärkers angeschlossen ist. Daher ist nur für den Transistor T1 ein Kollektorarbeitswiderstand R vorgesehen. Ein Ausgangsemitterfolger für invertierte Ausgangssignale müßte eine eigene Stromquelle in an sich bekannter Weise erhalten.

Zur Bildung einer ODER-Verknüpfung mehrerer Eingangssignale können zur Kollektor-Emitter-Strecke des Transistors T3 des Eingangsemitterfolgers die Kollektor-Emitter-Strecken weiterer Transistoren parallel geschaltet werden. Durch die Kollektorkapazitäten der zusätzlichen Transistoren steigt jedoch die kapazitive Belastung des Ausgangs A an. Zum Ausgleich müßte der von der Stromquelle Q2 gelieferte Strom I2 erhöht werden, so daß der durch die Erfindung erzielte Vorteil wenigstens teilweise wieder zunichte gemacht wird. Es empfiehlt sich daher nicht, in der Eingangs-Emitterfolgerstufe mehr als zwei bis drei Transistoren parallel zu schalten.

Beim Einsatz von erfindungsgemäßen Schaltungsanordnungen als Eingangsstufen von programmierbaren Logikanordnungen besteht die Möglichkeit, durch Anlegen einer gegen die kollektorseitige Versorgungsspannung $V_{CC}$ positiven Spannung an den Eingang E auch die Spannung am Ausgang A weit über die normalen Betriebswerte hinaus zu erhöhen. Das ermöglicht die Prüfung von unprogrammierten programmierbaren Logikanordnungen.

## Patentansprüche

1. Schaltungsanordnung in ECL-Schaltungstechnik mit einem Eingangsemitterfolger (T3, IQ2), einem Differenzverstärker mit emittergekoppelten Transistoren (T1, T2) und einem Ausgangsemitterfolger (T4) für das nichtinvertierte Ausgangssignal, dadurch gekennzeichnet, daß der Emitter des als Ausgangsemitterfolger betriebenen Transistors (T4) mit dem Kollektor des als Eingangsemitterfolger betriebenen Transistors (T3) verbunden ist.

2. Schaltungsanordnung nach Anspruch 1, dadurch gekennzeichnet, daß zur ODER-Verknüpfung mehrerer Eingangssignale der Kollektor-Emitter-Strecke des als Eingangsemitterfolger betriebenen Transistors (T3) die Kollektor-Emitter-Strecke mindestens eines weiteren Transistors parallel geschaltet ist, an dessen Basis ein weiteres Eingangssignal anliegt.

## Claims

1. An ECL circuit arrangement with an input emitter follower (T3, IQ2), a differential amplifier having emitter-coupled transistors (T1, T2), and an output emitter follower (T4) for the non-inverted output signal, characterised in that the emitter of the output emitter follower transistor (T4) is connected to the collector of the input emitter follower transistor (T3).

2. A circuit arrangement as claimed in Claim 1, characterised in that an OR logic link of a plurality of input signals is obtained by connecting the collector-emitter path of the transistor (T3) operated as input emitter follower in parallel with the collector-emitter path of at least one further transistor to whose base a further input signal is applied.

## Revendications

1. Montage selon la technique des circuits ECL comportant un émetteur-suiveur d'entrée (T3, JQ2), un amplificateur différentiel comprenant des transistors (T1, T2) accouplés par leurs émetteurs, et un émetteur-suiveur de sortie (T4) pour le signal de sortie non inversé, caractérisé par le fait que l'émetteur du transistor (T4) fonctionnant en tant qu'émetteur-suiveur de sortie est relié au collecteur du transistor (T3) fonctionnant en tant qu'émetteur-suiveur d'entrée.

2. Montage suivant la revendication 1, caractérisé par le fait que pour réaliser la combinaison OU de plusieurs signaux d'entrée, en parallèle avec la voie collecteur-émetteur du transistor (T3) fonctionnant en tant qu'émetteur-suiveur d'entrée se trouve branchée la voie collecteur-émetteur d'au moins un autre transistor, à la base duquel est appliqué un autre signal d'entrée.